# EUROPÄISCHE PATENTSCHRIFT

(11) **EP 2 733 556 B1**
(45) Veröffentlichungstag und Bekanntmachung des Hinweises auf die Patenterteilung: **25.12.2019**
(21) Anmeldenummer: 13193170.1
(22) Anmeldetag: 15.11.2013
(51) Int. Cl.: G05B 19/042, G01R 31/327

(54) **Sicherheitsbezogene Vorrichtung zum sicheren Schalten einer elektrischen Last**
Safety-related device for the safe switching of an electrical load
Dispositif lié à la sécurité pour la commutation sûre d'une charge électrique

(30) Priorität: 16.11.2012 DE 102012111070
(43) Veröffentlichungstag der Anmeldung: 21.05.2014
(73) Patentinhaber: Phoenix Contact GmbH & Co. KG, 32825 Blomberg (DE)
(72) Erfinder: Oster, Viktor, 32825 Blomberg (DE)
(74) Vertreter: Blumbach · Zinngrebe Patentanwälte PartG mbB

(56) Entgegenhaltungen:
- EP-A2- 0 730 348
- WO-A2-02/095282
- DE-A1-102009 017 275
- DE-A1-102011 003 733

## Beschreibung

Die Erfindung betrifft eine Schutzschaltung zur Verwendung mit einer Ausgangseinrichtung, die zum sicheren Schalten einer elektrischen Last ausgebildet ist, sowie eine sicherheitsbezogene Vorrichtung zum sicheren Schalten einer elektrischen Last mit einer solchen Schutzschaltung.

In der Sicherheitstechnik werden Ausgangsmodule eingesetzt, mit denen beispielsweise Gefahrenbereiche einer Maschine überwacht werden können. Bei solchen Ausgangsmodulen kann es sich um berührungslos wirkende Schutzeinrichtungen handeln, die wenigstens einen Sicherheitssensor und wenigstens einen elektronischen Ausgang aufweisen. Der elektronische Ausgang kann als ein OSSD (Output Signal Switching Device)-Ausgang ausgebildet sein, an welchem Schaltsignale zum sicheren Schalten einer elektrischen Last anliegen. Der elektronische Ausgang enthält einen Ausgangsschaltkreis, der einen oder mehrere Ausgangstreiber aufweisen kann. Um den hohen Sicherheitsanforderungen der Sicherheitstechnik zu genügen, müssen Ausgangsmodule hinsichtlich der Schaltfähigkeit, insbesondere der Abschaltfähigkeit der Ausgangstreiber getestet werden. Testeinrichtungen der Ausgangsmodule erzeugen hierzu Abschalt- und Einschalttestimpulse, die die Ausgangstreiber entsprechend ansteuern. Da die Abschalt- und Einschalttestimpulse jedoch am Ausgang des Ausgangsmoduls sichtbar sind, können sie einen unerwünschten Betriebszustandswechsel der angeschlossenen elektrischen Last auslösen. Ein solches Fehlverhalten, insbesondere ein unerwünschtes Einschalten einer angeschlossenen elektrischen Last während eines Hellimpulses ist zwingend zu vermeiden.

Eine Schaltungsanordnung, die ein solches Fehlverhalten vermeiden soll, ist aus der DE 10 2007 002 953 A1 bekannt. Die bekannte Schaltungsanordnung dient zur Ausgabe eines Schaltsignals an eine externe Last und sorgt dafür, dass bei einer Fehlerkontrolle der Betriebszustand der externen Last unverändert bleibt. Dies wird dadurch erreicht, dass das Umschalten eines Ausgangstreibers zur Fehlerkontrolle so kurzzeitig erfolgt, dass sich der Betriebszustand der Last nicht ändert. Ein Nachteil der bekannten Schaltungsanordnung ist darin zu sehen, dass schaltungstechnisch sichergestellt werden muss, dass Schaltsignale mit kurzer zeitlicher Länge erzeugt werden. Störungen in der Schaltungsanordnung, zum Beispiel altersbedingte Verschleißerscheinungen der elektronischen Komponenten, können dazu führen, dass die Impulsdauer der Umschaltimpulse derart verlängert wird, dass während der Fehlerkontrolle der Betriebszustand der Last sich in unerwünschter Weise ändert.

Aus der DE 10 2008 045 149 A1 ist ein Steuerungssystem mit einer Schaltungsanordnung zum Ein- und Ausschalten einer elektrischen Last bekannt. Die Schaltungsanordnung enthält ein Funktionsbauelement, welches einen Pufferkondensator und einen Schwellwertschalter aufweist. Das Funktionsbauelement dient zum einen dazu, die zum Schalten der elektrischen Last erforderliche Energie bereitzustellen. Zum anderen dient das Funktionsbauelement dazu, die von einem fehlersicheren Ausgang ausgehenden Testimpulse nicht an den Verbraucher weiterzugeben.

Ein Schwellwertschalter, der eine Reihenschaltung von Dioden aufweist ist aus der EP 0 396 812 A1 bekannt.

Aus der DE 10 2009 017 275 A1 ist eine Vorrichtung zur Überwachung der Schaltfähigkeit eines zur Schaltung eines elektrischen Verbrauchers dienenden Halbleiterschalters bekannt. Die bekannte Vorrichtung weist einen parallel zu einer Last geschalteten Pufferkondensator auf, um während eines Abschalttests eine ohmsche Last vom Abschaltimpuls entkoppeln und somit weiter betreiben zu können.

Aus der DE 10 2011 003 733 A1 ist eine Ansteuerschaltung zur Ansteuerung eines Transistors bekannt. Die Ansteuerschaltung weist ein RC-Glied in Form eines Tiefpassfilters auf, der verhindern soll, dass Spannungsspitzen während Einschwingvorgängen nach Ein- oder Ausschaltung des Transistors auftreten.

In der EP 0 730 348 A2 ist eine komplexe elektronische Schaltung zum Ein- und Ausschalten einer elektrischen Last beschrieben, mit der sowohl im eingeschalteten als auch im ausgeschalteten Zustand der Last eine Plausibilitätskontrolle zur Überprüfung der Halbleiterschalter und der Last durchgeführt werden kann.

Aus der WO 02/095282 A2 ist ein Sicherheitsschaltmodul zur Prüfung des Abschaltvermögens eines Schaltelements bekannt, welches zu einem erhöhten Platz- und Kostenaufwand führt.

Der Erfindung liegt die Aufgabe zugrunde, eine sicherheitsbezogene Vorrichtung und eine Schutzschaltung zu schaffen, die in kostengünstiger und flexibler Weise zuverlässig sowohl einen Helltest als auch einen Dunkeltest ermöglicht.

Ein Kerngedanke der Erfindung kann darin gesehen werden, mittels weniger passiver elektrischer Bauteile eine Schutzschaltung bereitzustellen, die dafür sorgt, dass während eines Dunkeltests der Ausgangseinrichtung der Abschalttestimpuls beispielsweise mittels einer kapazitiven Puffereinrichtung derart überbrückt wird, dass eine elektrische Last nicht in unerwünschter Weise abgeschaltet wird. Die Schutzschaltung kann ferner dafür sorgen, dass während eines Helltests der Ausgangseinrichtung die kapazitive Puffereinrichtung durch einen Einschalttestimpuls nicht über einen vorbestimmten Energie-Schwellwert geladen wird, so dass die elektrische Last während des Helltests nicht in unerwünschter Weise eingeschaltet werden kann.

Das oben genannte technische Problem wird zum einen durch die Merkmale des Anspruchs 1 gelöst.

Danach ist eine Schutzschaltung zur Verwendung mit einer sicheren Ausgangseinrichtung vorgesehen, welche zum sicheren Schalten einer elektrischen Last ausgebildet ist, wobei die Schutzschaltung folgende Merkmale aufweist:
eine kapazitive Puffereinrichtung, welche dazu ausgebildet ist, eine elektrische Last während eines Dunkeltests in einem eingeschalteten Betriebszustand zu halten, wobei die Schutzschaltung ferner eine Energiezufluss-Steuereinrichtung aufweist, die dazu ausgebildet ist, ein unerwünschtes Aufladen der kapazitiven Puffereinrichtung während eines Helltests über einen einstellbaren Schwellwert zu verhindern, wobei die Schutzschaltung eine erste Entkopplungsdiode, die zwischen einer Ausgangsschalteinrichtung und der elektrischen Last wirkt, und wenigstens zwei zweite Entkopplungsdiode aufweist, wobei
die kapazitive Puffereinrichtung ein Pufferkondensator ist, wobei
die Energiezufluss-Steuereinrichtung die wenigstens zwei zweiten Entkopplungsdioden und einen elektrischen Widerstand aufweist, der parallel zu den wenigstens zwei zweiten Entkopplungsdioden geschaltet ist, und wobei die Energiezufluss-Steuereinrichtung in Reihe mit dem Pufferkondensator (37) geschaltet ist.

Die Schutzschaltung kann als separates Bauteil, zum Beispiel in Form einer Klemme ausgebildet sein, welche erste Anschlüsse zum Verbinden mit der Ausgangseinrichtung und zweite Anschlüsse, an die eine elektrische Last anschaltbar ist, aufweist.

Der elektrische Widerstand kann ein Potentiometer sein.

Das oben genannte technische Problem wird ebenfalls mit den Merkmalen des Anspruchs 6 gelöst.

Danach ist eine sicherheitsbezogene Vorrichtung zum sicheren Schalten einer elektrischen Last vorgesehen wobei die Vorrichtung eine mit dem sicheren Schaltausgangsanschluss und dem weiteren Anschluss verbindbare Schutzschaltung aufweist. Bei der elektrischen Last kann es sich um eine Maschine, eine Anlage, ein Sicherheitsrelais und vieles mehr handeln.

Die sicherheitsbezogene Vorrichtung weist wenigstens eine sichere Ausgangseinrichtung, auch als Ausgangsmodul bekannt, auf. Die sichere Ausgangseinrichtung weist wenigstens einen sicheren Schaltausgangsanschluss und einen weiteren Anschluss zum Anschalten einer elektrischen Last auf. Der weitere Anschluss kann ein Masseanschluss sein. Bei dem sicheren Schaltausgangsanschluss kann es sich um einen elektronischen OSSD (Output Signal Switching Device)-Ausgang handeln.

Die Ausgangseinrichtung weist weiterhin eine sichere, mit dem sicheren Schaltausgangsanschluss verbundene, ansteuerbare Ausgangsschalteinrichtung auf, die dazu ausgebildet ist, Schaltsignale zum sicheren Schalten der elektrischen Last zu erzeugen. Die Ausgangsschalteinrichtung kann mehrere Ausgangstreiber enthalten.

Weiterhin enthält die Ausgangseinrichtung eine mit der Ausgangsschalteinrichtung verbundene Testeinrichtung, die zum Erzeugen von Einschalt- und Abschalttestimpulsen ausgebildet ist, um einen Hell- bzw. Dunkeltest durchzuführen. Die Einschalt- und Abschalttestimpulse werden nachfolgend auch Helltest- bzw. Dunkeltestimpulse genannt. Vorzugsweise kann während eines Helltest die Einschaltfähigkeit und während eines Dunkeltests die Abschaltfähigkeit der Ausgangseinrichtung, insbesondere deren Ausgangsschalteinrichtung geprüft werden.

Die Schutzschaltung kann eine erste Entkopplungsdiode aufweisen, die vorzugsweise zwischen der Ausgangsschalteinrichtung und der elektrischen Last wirkt. Die kapazitive Puffereinrichtung der Schutzschaltung kann ein Pufferkondensator sein. Die Energiezufluss-Steuereinrichtung der Schutzschaltung kann einen elektrischen Widerstand und wenigstens eine zweite, parallel zum elektrischen Widerstand geschaltete Entkopplungsdiode aufweisen, wobei die Energiezufluss-Steuereinrichtung in Reihe mit dem Pufferkondensator geschaltet sein kann.

Um zu gewährleisten, dass der Pufferkondensator während eines Helltests nicht über den einstellbaren Schwellwert aufgeladen wird, können der elektrische Widerstand und der Pufferkondensator, welche zusammen ein RC-Glied bilden, in geeigneter Weise dimensioniert werden. Das heißt, die Aufladezeit des RC-Glieds kann in Abhängigkeit der verwendeten elektrischen und elektronischen Komponenten der sicherheitsbezogenen Vorrichtung eingestellt werden. Auf diese Weise kann auch eine durch Störungen verursachte, unerwünschte Verlängerung der Dauer eines Einschalttestimpulses zugelassen werden, ohne dass während eines Helltests die elektrische Last eingeschaltet wird.

Um zu verhindern, dass während eines Helltests die angeschlossene elektrische Last in unerwünschter Weise eingeschaltet wird, kann das RC-Glied in Abhängigkeit von der Dauer eines Einschalttestimpulses und einer definierten Fehlererkennungszeit einer Überwachungseinrichtung zum Erkennen eines Fehlers der Ausgangsschalteinrichtung dimensioniert sein. Auf diese Weise kann auch eine durch Störungen verursachte, unerwünschte Verlängerung der Dauer eines Einschalttestimpulses zugelassen werden, ohne dass während eines Helltests die elektrische Last eingeschaltet wird.

Die Schutzschaltung kann einen weiteren, zwischen den Schaltausgangsanschluss und den weiteren Anschluss geschalteten elektrischen Widerstand aufweisen. Dieser Widerstand wirkt während eines Dunkeltest wie eine kleine elektrische Last und sorgt dafür, dass die Ausgangsschalteinrichtung auch bei stromlosem Betrieb des sicheren Schaltausgangsanschlusses stabil arbeitet.

Die Schutzschaltung kann in der elektrischen Last implementiert sein.

Denkbar ist auch, dass die Schutzschaltung in der sicheren Ausgangseinrichtung implementiert ist.

Die Erfindung wird nachfolgend anhand eines Ausführungsbeispiels in Verbindung mit den beiliegenden Zeichnungen näher erläutert. Es zeigen:
- Fig. 1: eine sicherheitsbezogene Vorrichtung mit einer als Klemme ausgebildeten erfindungsgemäßen Schutzschaltung und
- Fig. 2: eine alternative sicherheitsbezogene Vorrichtung, in der die erfindungsgemäße Schutzschaltung in einer elektrischen Last implementiert ist.

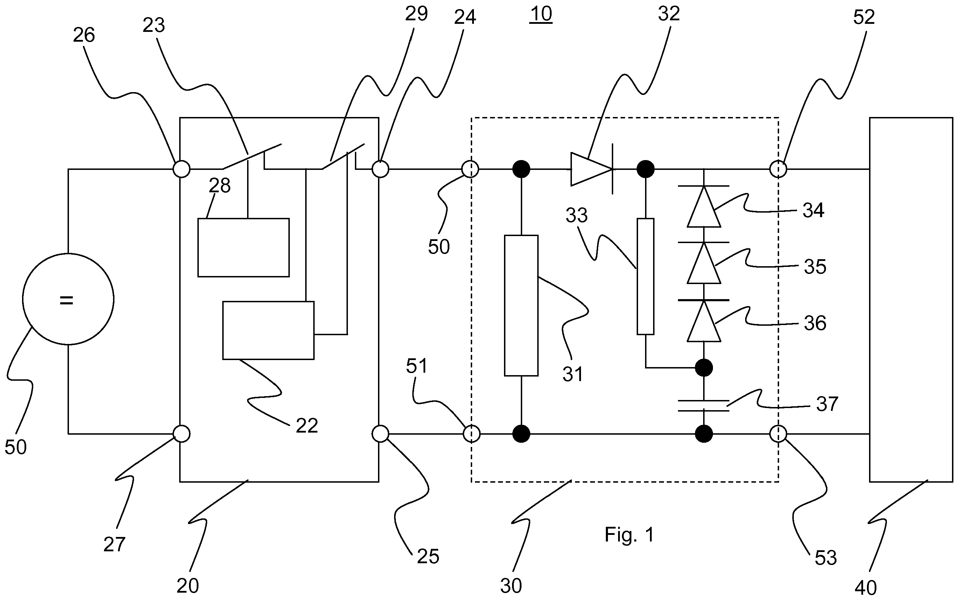

Figur 1 zeigt eine beispielhafte sicherheitsbezogene Vorrichtung 10, die eine sichere Ausgangseinrichtung 20, eine externe elektrische Last 40 und eine als Klemme ausgebildete Schutzschaltung 30 aufweist, die zwischen der Ausgangseinrichtung 20 und der elektrischen Last 40 geschaltet ist.

Bei der Ausgangseinrichtung 20 kann es sich um eine an sich bekannte, berührungslos wirkende Schutzeinrichtung mit einem oder mehreren Sicherheitssensoren (nicht dargestellt) handeln. Die Ausgangseinrichtung 20, die auch als Ausgangsmodul bezeichnet werden kann, weist eine ansteuerbare Ausgangsschalteinrichtung 23 auf, die symbolisch durch einen Schalter 23 dargestellt ist. Es können auch mehrere Ausgangsschalteinrichtungen vorgesehen sein. In der Praxis weist die Ausgangsschalteinrichtung 23 einen oder mehrere Ausgangstreiber auf, die einen Feldeffekttransistor oder Feldeffekttransistor enthalten können. Die ansteuerbare Ausgangsschalteinrichtung 23 kann über eine Steuereinrichtung 28 angesteuert werden, die sowohl Testimpulse für die Durchführung von Dunkel- und Helltests als auch Schaltimpulse der Ausgangsschalteinrichtung 23 zuführen kann, mit denen die elektrische Last gezielt ein- oder abschalten werden kann.

Weiterhin ist in der Ausgangseinrichtung 20 eine Überwachungseinrichtung 22 vorgesehen, die einen sicheren Schaltausgangsanschluss 24 der Ausgangseinrichtung 20 und somit die Ausgangsschalteinrichtung 23 auf Fehler überwachen kann. Die Überwachungseinrichtung 22 ist ferner dazu ausgebildet, bei Auftritt eines Fehlers einen in Reihe mit der Ausgangsschalteinrichtung 23 geschalteten Schalter 29 zu öffnen, sodass die angeschlossene elektrische Last 40 in einen sicheren Zustand gefahren werden kann. Ausgangsschalteinrichtung 23 und Schalter 29 sind zwischen einem ersten Eingangsanschluss 26 und dem Schaltausgangsanschluss 24 der Ausgangseinrichtung 20 geschaltet.

Die Ausgangseinrichtung 20 verfügt über einen zweiten Eingangsanschluss 27. An den ersten Ausgangsanschluss 26 und den zweiten Ausgangsanschluss 27 ist eine Gleichspannungsquelle 50 angeschlossen. Anstelle einer Gleichspannungsquelle kann auch eine Konstantstromquelle angeschlossen werden. Darüber hinaus weist die Ausgangseinrichtung 20 neben dem sicheren Schaltausgangsanschluss 24 noch und einen weiteren Ausgangsanschluss 25 auf. Der weitere Ausgangsanschluss 25 kann ein Masseanschluss sein.

Bei der in Fig. 1 gezeigten Vorrichtung 10 ist die klemmenförmige Schutzschaltung 30 an den Schaltausgangsanschluss 24 und den Ausgangsanschluss 25 angeschlossen. Hierzu weist die klemmenförmige Schutzschaltung 30 zwei Anschlüsse 50 und 51 auf. Über Anschlüsse 52 und 53 ist die Schutzschaltung 30 mit der elektrischen Last 40 verbunden. Vorzugsweise enthält, wie in Fig. 1 gezeigt, die Schutzschaltung 30 nur passive, elektrische Bauteile.

Die Schutzschaltung 30 weist eine Entkopplungsdiode 32 auf, die zwischen der Ausgangsschalteinrichtung 23 und der elektrischen Last 40 derart wirkt, dass interne Kapazitäten der elektrischen Last 40 von dem Schaltausgangsanschluss 24 und somit von der Ausgangsschalteinrichtung 23 entkoppelt werden. Folglich ist der Anodenanschluss der Entkopplungsdiode 32 mit dem Anschluss 50 der Schutzschaltung 30 und der Kathodenanschluss mit dem Anschluss 52 der Schutzschaltung 30 verbunden.

Die Schutzschaltung 30 weist ferner einen elektrischen Widerstand 31 auf, der mit den Anschlüsse 50 und 51 verbunden ist und somit zwischen dem sicheren Schaltausgangsanschluss 24 und dem weiteren Anschluss 25 der Ausgangseinrichtung 20 liegt. Der Widerstand 31 wirkt während eines Dunkeltests der Ausgangseinrichtung 20 als kleine elektrische Last anstelle der elektrischen Last 40, zu der während eines Dunkeltests kein Strom von der Ausgangseinrichtung 20 fließt.

Die Schutzschaltung 30 weist weiterhin eine kapazitive Puffereinrichtung 37 auf, die als Pufferkondensator ausgebildet sein kann. Ein Anschluss des Pufferkondensators 37 ist mit dem Anschluss 53 der Schutzschaltung 30 verbunden, während der andere Anschluss des Pufferkondensators 37 mit dem Anodenanschluss einer Entkopplungsdiode 36 verbunden ist. Im vorliegenden Beispiel ist die Entkopplungsdiode 36 in Reihe mit zwei weiteren Entkopplungsdioden 35 und 35 geschaltet, wobei der Kathodenanschluss der Entkopplungsdiode 36 mit dem Anodenanschluss der Entkopplungsdiode 35 verbunden ist. Der Kathodenanschluss der Entkopplungsdiode 35 ist mit dem Anodenanschluss der Entkopplungsdioden 34 verbunden, deren Kathodenanschluss mit dem Anschluss 52 der Schutzschaltung verbunden ist. Die Entkopplungsdioden 34 bis 36 entkoppeln den Pufferkondensator 37 vom Schaltausgangsanschluss 24 der Ausgangseinrichtung 20 und verhindern damit, dass der Pufferkondensator 37 durch einen von der Ausgangseinrichtung 20 gelieferten Einschaltimpuls sofort vollständig aufgeladen wird. Im vorliegenden Beispiel wurden drei Entkopplungsdioden 34 bis 36 gewählt, um den Pufferkondensator 37 zuverlässig von der Ausgangsschalteinrichtung 23 zu entkoppeln, auch wenn ein oder zwei Entkopplungsdioden ausfallen.

Der Pufferkondensators 37 dient vorzugsweise dazu, während eines in der Ausgangseinrichtung 20 durchgeführten Dunkeltests den am Schaltausgangsanschluss 24 anliegenden Abschalttestimpuls derart zu überbrücken, d.h. zu puffern, dass die elektrische Last 40 nicht fälschlicher Weise den Abschalttestimpuls als Abschaltsignal interpretiert und somit die elektrische Last in unerwünschter Weise abgeschaltet wird.

Parallel zu den Entkopplungsdioden 34 bis 36 ist ein Widerstand 33 geschaltet, der zusammen mit den Entkopplungsdioden 34 bis 36 eine Energiezufluss-Steuereinrichtung bildet. Die Energiezufluss-Steuereinrichtung, ist dazu ausgebildet, den Stromfluss von der Ausgangseinrichtung 20 zum Pufferkondensator 37 während eines Helltests derart zu steuern, dass ein unerwünschtes Aufladen des Pufferkondensators 37 über einen vorbestimmten Schwellwert verhindert wird. Angemerkt sei an dieser Stelle, dass die Entkopplungsdiode 32 ebenfalls verhindert, dass sich der Pufferkondensator 37 in die Ausgangseinrichtung 20 entladen kann.

Der Widerstand 33 und der Pufferkondensator 37 bilden ein RC-Glied, das so dimensioniert ist, dass während eines Helltests der Pufferkondensator 37 nicht über einen einstellbaren Schwellwert aufgeladen werden kann. Der einstellbare Schwellwert ist so niedrig gewählt, dass die im Pufferkondensator 37 unterhalb des Schwellwerts gespeicherte Energie von der elektrischen Last 40 nicht fälschlicher Weise als Einschaltimpuls erkannt werden kann.

Mit anderen Worten wird die Aufladezeitkonstante des RC-Glieds so eingestellt, dass die zu erwartenden Helltestimpulse den Pufferkondensator 37 nicht über den vorbestimmten Schwellwert aufladen. Der Widerstand 33 kann deshalb als Potentiometer ausgebildet sein.

Dank dieser flexibel dimensionierbaren Energiezufluss-Steuereinrichtung ist gewährleistet, dass die elektrische Last 40 während eines Helltests auch dann nicht unerwünscht eingeschaltet wird, wenn störungsbedingt ein Helltestimpuls zeitlich verlängert wird. Einen entsprechenden zeitlichen Toleranzbereich berücksichtigt die Energiezufluss-Steuereinrichtung.

Das RC-Glied, welches den Widerstand 33 und den Pufferkondensator 37 enthält, kann auch in Abhängigkeit von der Dauer eines Helltestimpulses, auch Einschalttestimpuls genannt, und einer definierten Fehlererkennungszeit der Überwachungseinrichtung 22, die zum Erkennen eines Fehlers der Ausgangseinrichtung 20 benötigt wird, dimensioniert werden. Auch durch diese Maßnahme wird gewährleistet, dass die elektrische Last 40 während eines Helltests auch dann nicht unerwünscht eingeschaltet wird, wenn störungsbedingt ein Helltestimpuls zeitlich verlängert wird.

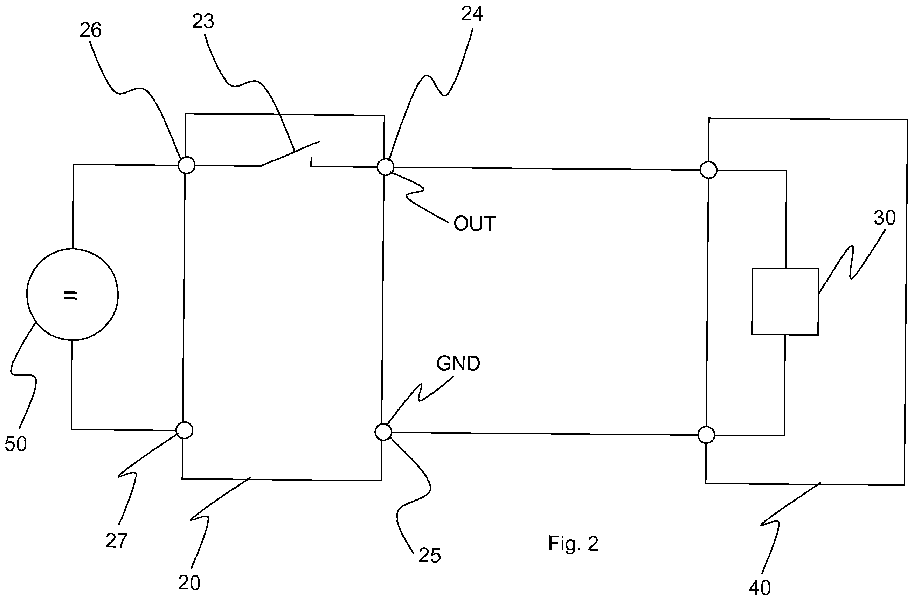

Figur 2 zeigt eine alternative sicherheitsbezogene Vorrichtung mit der in Figur 1 gezeigten Ausgangseinrichtung 20 und einer elektrischen Last 40. Im Unterschied zu der in Figur 1 gezeigten sicherheitsbezogenen Vorrichtung ist die Schutzschaltung 30 in der elektrischen Last 40 implementiert.

Der Vollständigkeit halber sei erwähnt, dass die Schutzschaltung 30 auch in der Ausgangseinrichtung 20 implementiert sein könnte, wobei in diesem Fall die Anschlüsse 52 und 53 der Schutzschaltung mit dem sicheren Schaltausgangsanschluss 24 und dem weiteren Anschluss 25 zusammenfallen würden.

Die Funktionsweise der in Figur 1 gezeigten sicherheitsbezogenen Vorrichtung wird nachfolgend näher erläutert.

Angenommen sei, dass sich die elektrische Last 40 in einem deaktivierten Betriebszustand befindet, d.h. die Ausgangsschalteinrichtung 23 befindet sich im geöffneten oder hochohmigen Zustand. Nunmehr soll die Einschaltfähigkeit der Ausgangsschalteinrichtung 23 getestet werden, d.h. ein Helltest durchgeführt werden.

Die Steuereinrichtung 28 liefert nun einen Einschalttestimpuls, welcher die Dauer des Helltests bestimmt. Unter Ansprechen auf den Einschalttestimpuls wird der symbolische Schalter 23 geschlossen. Mit anderen Worten wird die Ausgangsschalteinrichtung 23 in den niederohmigen Zustand gesteuert. In diesem Moment fließt über den Schaltausgangsanschluss 24 ein elektrischer Strom, der durch die Gleichspannungsquelle 50 hervorgerufen wird. Die Energiezufluss-Steuereinrichtung, die die Entkopplungsdioden 34 bis 36 und den Widerstand 33 enthält, sorgt nunmehr dafür, dass während des Helltests der Pufferkondensator 37 nicht über den eingestellten Schwellwert, der unterhalb der Amplitude des Einschalttestimpulses liegt, aufgeladen wird. Demzufolge wird die Dauer des Einschalttestimpulses durch den Pufferkondensator 37 nicht verlängert und die elektrische Last 40 wird nicht in unerwünschter Weise eingeschaltet. Denn die Entkopplungsdioden 34 bis 36 verhindern, dass der Einschalttestimpuls direkt den Pufferkondensator 37 auflädt.

Die Entkopplungsdioden 34 und 36 verhindern ferner ein schnelles Aufladen des Pufferkondensators 37, wenn zum Beispiel durch einen internen Fehler der Ausgangseinrichtung 20 der sichere Schaltausgangsanschluss 24 bzw. die Ausgangsschalteinrichtung 23 eingeschaltet wird. Auch in diesem Fall wird verhindert, dass ein fehlerbedingter Einschaltimpuls verlängert wird, der eine Fehlinterpretation in der elektrischen Last 40 zur Folge haben könnte. Die Überwachungseinrichtung 22 hat somit ausreichend Zeit, eine fehlerhaft eingeschaltete Ausgangsschalteinrichtung 23 zu erkennen und den Schalter 29 zu öffnen, sodass die angeschlossene elektrische Last nicht eingeschaltet wird bzw. in einen sicheren Zustand gefahren werden kann.

Angenommen sei nunmehr, dass die Schalter 23 und 29 geschlossen sind und somit die elektrische Last 40 aktiviert ist. Ferner sei angenommen, dass der Pufferkondensator 37 vollständig aufgeladen ist.

Nunmehr soll in der Ausgangseinrichtung 20 ein Dunkeltest durchgeführt werden, um die Abschaltfähigkeit der Ausgangsschalteinrichtung 23 zu testen. In diesem Fall erzeugt die Steuereinrichtung 28 einen Abschalttestimpuls, der dafür sorgt, dass die Ausgangsschalteinrichtung 23 geöffnet wird.

Um zu verhindern, dass die eingeschaltete elektrischen Last 40 während des Dunkeltests in unerwünschter Weise durch den Abschalttestimpuls, der nämlich am Schaltausgangsanschluss 24 zu sehen ist, abgeschaltet wird, entlädt sich der Pufferkondensator 37 über die Entkopplungsdioden 34 bis 36 in die elektrische Last 40. Demzufolge erkennt die elektrische Last 40 nach wie vor den aktiven Zustand an ihrem Eingang. Mit anderen Worten puffert der Pufferkondensator 37 die Spannung an der elektrischen Last 40 für die Dauer eines Dunkeltests soweit ab, dass die elektrische Last 40 keinen Abschaltimpuls erkennt und nicht in unerwünschter Weise abgeschaltet wird.

## Patentansprüche

1. Schutzschaltung (30) zur Verwendung mit einer sicheren Ausgangseinrichtung (20), welche zum sicheren Schalten einer elektrischen Last (40) ausgebildet ist, wobei die Schutzschaltung (30) folgende Merkmale aufweist:
eine kapazitive Puffereinrichtung (37), welche dazu ausgebildet ist, eine elektrische Last (40) während eines Dunkeltests in einem eingeschalteten Betriebszustand zu halten, wobei die Schutzschaltung (30) ferner eine Energiezufluss-Steuereinrichtung (33-36) aufweist, die dazu ausgebildet ist, ein unerwünschtes Aufladen der kapazitiven Puffereinrichtung während eines Helltests über einen einstellbaren Schwellwert zu verhindern, wobei die Schutzschaltung (30) eine erste Entkopplungsdiode (32), die zwischen einer Ausgangsschalteinrichtung (23) und der elektrischen Last (40) wirkt, und wenigstens zwei zweite Entkopplungsdiode (34-36) aufweist, wobei
die kapazitive Puffereinrichtung (37) ein Pufferkondensator ist, wobei
die Energiezufluss-Steuereinrichtung die wenigstens zwei zweiten Entkopplungsdioden (34-36) und einen elektrischen Widerstand (33) aufweist, der parallel zu den wenigstens zwei zweiten Entkopplungsdioden (34-36) geschaltet ist, und wobei die Energiezufluss-Steuereinrichtung in Reihe mit dem Pufferkondensator (37) geschaltet ist.

2. Schutzschaltung nach Anspruch 1,
**dadurch gekennzeichnet, dass**
der elektrische Widerstand (33) und der Pufferkondensator (37) ein RC-Glied bilden, welches derart dimensioniert ist, dass der Pufferkondensator (37) während eines Helltests nicht über den einstellbaren Schwellwert aufgeladen wird.

3. Schutzschaltung nach Anspruch 2,
**dadurch gekennzeichnet, dass**
das RC-Glied (33, 37) in Abhängigkeit von der Dauer eines Einschalttestimpulses und einer definierten Fehlererkennungszeit einer Überwachungseinrichtung (22) zum Erkennen eines Fehlers der Ausgangsschalteinrichtung (23) dimensioniert ist.

4. Schutzschaltung nach einem der vorstehenden Ansprüche,
**dadurch gekennzeichnet, dass**
die Schutzschaltung (30) als Klemme ausgebildet ist, welche erste Anschlüsse (50, 51) zum Verbinden mit einer Ausgangseinrichtung (20) und zweite Anschlüsse (52, 53) aufweist, an die eine elektrische Last (40) anschaltbar ist.

5. Schutzschaltung nach einem der vorstehenden Ansprüche,
**dadurch gekennzeichnet, dass**
der elektrische Widerstand (33) ein Potentiometer ist.

6. Sicherheitsbezogene Vorrichtung (10) zum sicheren Schalten einer elektrischen Last (40), mit wenigstens einer sicheren Ausgangseinrichtung (20), welche folgende Merkmale aufweist:
einen sicheren Schaltausgangsanschluss (24) und einen weiteren Anschluss (25) zum Anschalten einer elektrischen Last (40),
eine sichere, mit dem sicheren Schaltausgangsanschluss (24) verbundene ansteuerbare Ausgangsschalteinrichtung (23), die dazu ausgebildet ist, Schaltsignale zum sicheren Schalten der elektrischen Last (40) zu erzeugen, und
eine mit der Ausgangsschalteinrichtung (23) verbundene Testeinrichtung, die zum Erzeugen von Einschalt- und Abschalttestimpulsen ausgebildet ist, um einen Hell- bzw. Dunkeltest durchzuführen;
und mit
einer mit dem Schaltausgangsanschluss (24) und dem weiteren Anschluss (25) verbindbaren Schutzschaltung (30) nach einem der Ansprüche 1 bis 3.

7. Sicherheitsbezogene Vorrichtung nach Anspruch 6,
**dadurch gekennzeichnet, dass**
die Schutzschaltung (30) einen weiteren, zwischen den Ausgangsanschluss (24) und den weiteren Anschluss (25) geschalteten elektrischen Widerstand (31) aufweist.

8. Sicherheitsbezogene Vorrichtung nach Anspruch 6 oder 7,
**dadurch gekennzeichnet, dass**
die Schutzschaltung (30) in der elektrischen Last (40) implementiert ist.

9. Sicherheitsbezogene Vorrichtung nach Anspruch 6 oder 7,
**dadurch gekennzeichnet, dass**
die Schutzschaltung (30) in der sicheren Ausgangseinrichtung (20) implementiert ist.

## Claims

1. A protection circuit (30) for use with a safe output device (20) adapted for safely switching an electrical load (40), the protection circuit (30) comprising the following features:
a capacitive buffer device (37) adapted to hold an electrical load (40) in an ON operation state during a dark test, the protection circuit (30) further comprising a power feed control device (33 - 36) adapted to prevent the capacitive buffer device from undesirably being charged beyond an adjustable threshold value during a light test, wherein the protection circuit (30) has a first decoupling diode (32) that is effective between an output switching device (23) and the electrical load (40), and at least two second decoupling diodes (34 - 36); wherein
the capacitive buffer device (37) is a buffer capacitor; wherein
the power feed control device comprises the at least two second decoupling diodes (34 - 36) and an electrical resistor (33) connected in parallel to the at least two second decoupling diodes (34 - 36), and wherein the power feed control device is connected in series with the buffer capacitor (37).

2. The protection circuit according to claim 1,
**characterized in that**
the electrical resistor (33) and the buffer capacitor (37) form an RC circuit which is dimensioned such that the buffer capacitor (37) is not charged beyond the adjustable threshold value during a light test.

3. The protection circuit according to claim 2,
**characterized in that**
the RC circuit (33, 37) is dimensioned so as to detect a fault of the output switching device (23) as a function of the duration of a switch-on test pulse and a defined fault detection time of a monitoring device (22).

4. The protection circuit according to any one of the preceding claims, **characterized in that** the protective circuit (30) is in the form of a terminal block which has first terminals (50, 51) for being connected to an output device (20) and second terminals (52, 53) to which an electrical load (40) can be connected.

5. The protection circuit according to any one of the preceding claims, **characterized in that** the electrical resistor (33) is a potentiometer.

6. A safety-related device (10) for safely switching an electrical load (40), comprising
at least one safe output device (20) having the following features:
a safe switching output terminal (24) and a further terminal (25) for connecting an electrical load (40);
a safe controllable output switching device (23) connected to the safe switching output terminal (24) and configured to generate switching signals for safely switching the electrical load (40); and
a test device connected to the output switching device (23), which is configured to generate switch-on and switch-off test pulses in order to perform a light test or dark test; and comprising
a protective circuit (30) according to any one of claims 1 to 3, which is connectable to the switching output terminal (24) and the further terminal (25).

7. The safety-related device according to claim 6,
**characterized in that**
the protective circuit (30) has a further electrical resistor (31), connected between the output terminal (24) and the further terminal (25).

8. The safety-related device according to claim 6 or 7,
**characterized in that**
the protection circuit (30) is implemented in the electrical load (40).

9. The safety-related device according to claim 6 or 7,
**characterized in that**
the protection circuit (30) is implemented in the safe output device (20).

## Revendications

1. Circuit de protection (30) destiné à une utilisation avec un équipement de sortie (20) fiable qui est conçu pour une commutation fiable d'une charge électrique (40), où le circuit de protection (30) présente les caractéristiques suivantes : un équipement tampon (37) capacitif qui est conçu pour maintenir une charge électrique (40) pendant un test d'obscurité dans un état de fonctionnement commuté, où le circuit de protection (30) présente en outre un équipement de guidage d'afflux d'énergie (33-36) qui est conçu pour empêcher, au-dessus d'une valeur-seuil réglable, une recharge non souhaitée de l'équipement tampon capacitif pendant un test de clarté, où le circuit de protection (30) présente une première diode de découplage (32), qui agit entre un équipement de commutation de sortie (23) et la charge électrique (40), et au moins deux secondes diodes de découplage (34-36), où l'équipement tampon (37) est un condensateur tampon, où l'équipement de guidage d'afflux d'énergie présente les au moins deux secondes diodes de découplage (34-36) et une résistance électrique (33) qui est montée en parallèle des au moins deux secondes diodes de découplage (34-36), et où l'équipement de guidage d'afflux d'énergie est monté en série avec le condensateur tampon (37).

2. Circuit de protection selon la revendication 1, **caractérisé en ce que**
la résistance électrique (33) et le condensateur tampon (37) forment un circuit RC qui est dimensionné de telle sorte que le condensateur tampon (37) ne soit pas chargé au-dessus de la valeur-seuil réglable pendant un test de clarté.

3. Circuit de protection selon la revendication 2, **caractérisé en ce que**
le circuit RC (33, 37) est dimensionné en fonction de la durée d'une impulsion de test de mise en marche et d'une période de reconnaissance d'erreur définie d'un équipement de surveillance (22) pour reconnaître une erreur de l'équipement de commutation de sortie (23) .

4. Circuit de protection selon l'une des revendications précédentes, **caractérisé en ce que**
le circuit de protection (30) est conçu en tant que borne qui présente des premiers raccordements (50, 51) pour liaison à un équipement de sortie (20) et des seconds raccordements (52, 53) contre lesquels une charge électrique (40) peut être commutée.

5. Circuit de protection selon l'une des revendications précédentes, **caractérisé en ce que**
la résistance électrique (33) est un potentiomètre.

6. Dispositif relatif à la sécurité (10) pour une commutation fiable d'une charge électrique (40), avec au moins un équipement de sortie (20) fiable, qui présente les caractéristiques suivantes :
un raccordement de sortie de commutation (24) fiable et un autre raccordement (25) pour commuter une charge électrique (40),
un équipement de commutation de sortie (23) fiable et pouvant être guidé, relié au raccordement de sortie de commutation (24) fiable, qui est conçu pour produire des signaux de commutation pour une commutation fiable de la charge électrique (40), et
un équipement de test relié à l'équipement de commutation de sortie (23), conçu pour produire des impulsions de test de mise en marche et d'arrêt afin d'effectuer un test de clarté ou un test d'obscurité ;
et avec un circuit de protection (30) selon l'une des revendications 1 à 3 pouvant être relié au raccordement de sortie de commutation (24) et à l'autre raccordement (25).

7. Dispositif relatif à la sécurité selon la revendication 6, **caractérisé en ce que**
le circuit de protection (30) présente une autre résistance électrique (31) montée entre le raccordement de sortie (24) et l'autre raccordement (25).

8. Dispositif relatif à la sécurité selon la revendication 6 ou 7, **caractérisé en ce que**
le circuit de protection (30) est mis en œuvre dans la charge électrique (40).

9. Dispositif relatif à la sécurité selon la revendication 6 ou 7, **caractérisé en ce que**
le circuit de protection (30) est mis en œuvre dans l'équipement de sortie (20) fiable.
